# EUROPEAN PATENT APPLICATION

(11) **EP 4 796 945 A1**
(43) Date of publication of application: **26.08.2026**
(21) Application number: 26160302.1
(22) Date of filing: 24.02.2026
(51) Int. Cl.: G01R 33/00, G01R 33/02

(54) **MAGNETIC SENSOR MODULE AND MAGNETIC FIELD DETECTION DEVICE HAVING THE SAME**

(30) Priority: 25.02.2025 JP 2025027865
(71) Applicant: TDK Corporation, Tokyo 103-6128 (JP)
(72) Inventor: AKUSHICHI, Taiju, 4024 Laguna (PH); KAMI, Masafumi, Tokyo, 103-6128 (JP); KASAJIMA, Tamon, Tokyo, 103-6128 (JP)
(74) Representative: Epping - Hermann - Fischer

(57) **Abstract**

Disclosed herein is a magnetic sensor module that includes a support body, a magnetic sensor fixed to the support body, a first circuit board fixed to the support body and connected to the magnetic sensor, a connection member fixed to the first circuit board, and a second circuit board fixed to the first circuit board through the connection member and connected to the magnetic sensor through the connection member and the first circuit board. The connection member supports the second circuit board so as to form a space between the first circuit board and the second circuit board.

## Description

### BACKGROUND OF THE ART

### --Field of the Art

The present disclosure relates to a magnetic sensor module and, more particularly, to a magnetic sensor module having excellent heat dissipation performance. The present disclosure also relates to a magnetic field detection device that includes a plurality of such magnetic sensor modules and is capable of detecting a magnetic field in three axial directions.

### --Description of Related Art

Japanese Utility Model Laid-Open No. Sho 58-047181 discloses a magnetic field detection device capable of detecting a magnetic field in three axial directions.

However, the magnetic field detection device disclosed in Japanese Utility Model Laid-Open No. Sho 58-047181 has no space for accommodating various circuits to be connected to a magnetic sensor, and thus needs to be separately connected to a circuit board having the circuits thereon.

### SUMMARY

The present disclosure describes a magnetic sensor module applicable to a magnetic field detection device capable of detecting a magnetic field in three axial directions and having a structure in which a magnetic sensor and various circuits are integrated.

A magnetic sensor module according to an aspect of the present disclosure includes: a support body; a magnetic sensor fixed to the support body; a first circuit board fixed to the support body and connected to the magnetic sensor; a connection member fixed to the first circuit board; a second circuit board fixed to the first circuit board through the connection member and connected to the magnetic sensor through the connection member and the first circuit board. The connection member supports the second circuit board so as to form a space between the first circuit board and the second circuit board.

According to the present disclosure, a magnetic sensor module having a structure in which a magnetic sensor and various circuits are integrated is provided.

### BRIEF DESCRIPTION OF THE DRAWINGS

The above features and advantages of the present disclosure will be more apparent from the following description of some embodiments taken in conjunction with the accompanying drawings, in which:
FIGS. 1A and 1B are schematic perspective views illustrating the outer appearance of a magnetic field detection device 10 according to an embodiment of the technology described herein, as viewed from different directions;
FIG. 2 is a schematic perspective view illustrating a state in which the fixing member 400 is removed from the magnetic field detection device 10;
FIG. 3 is a schematic perspective view illustrating a state in which the magnetic sensor module 200 is removed from the magnetic field detection device 10;
FIG. 4 is a schematic perspective view illustrating a state in which the magnetic sensor module 300 is removed from the magnetic field detection device 10;
FIG. 5 is a schematic perspective view illustrating a state in which the cube body constituting the magnetic field detection device 10 is accommodated in an outer case 30;
FIGS. 6A and 6B are schematic perspective views illustrating the outer appearance of the magnetic sensor module 100, as viewed from different directions;
FIGS. 7A and 7B are schematic perspective views illustrating the outer appearance of the support body 110, as viewed from different directions;
FIG. 8 is a circuit diagram illustrating an example of a circuit formed in the magnetic sensor 120 and the circuit boards 130 and 140;
FIGS. 9A and 9B are schematic perspective views illustrating the outer appearance of the magnetic sensor module 200, as viewed from different directions;
FIGS. 10A and 10B are schematic perspective views illustrating the outer appearance of the support body 210, as viewed from different directions;
FIGS. 11A and 11B are schematic perspective views illustrating the outer appearance of the magnetic sensor module 300, as viewed from different directions;
FIGS. 12A and 12B are schematic perspective views illustrating the outer appearance of the support body 310, as viewed from different directions;
FIGS. 13A and 13B are schematic perspective views illustrating the outer appearance of the fixing member 400, as viewed from different directions; and
FIG. 14 is a schematic view of a cube body 40 formed by the magnetic sensor modules 100, 200, and 300.

### DETAILED DESCRIPTION OF THE EMBODIMENTS

Some embodiments of the present disclosure will be explained below in detail with reference to the accompanying drawings.

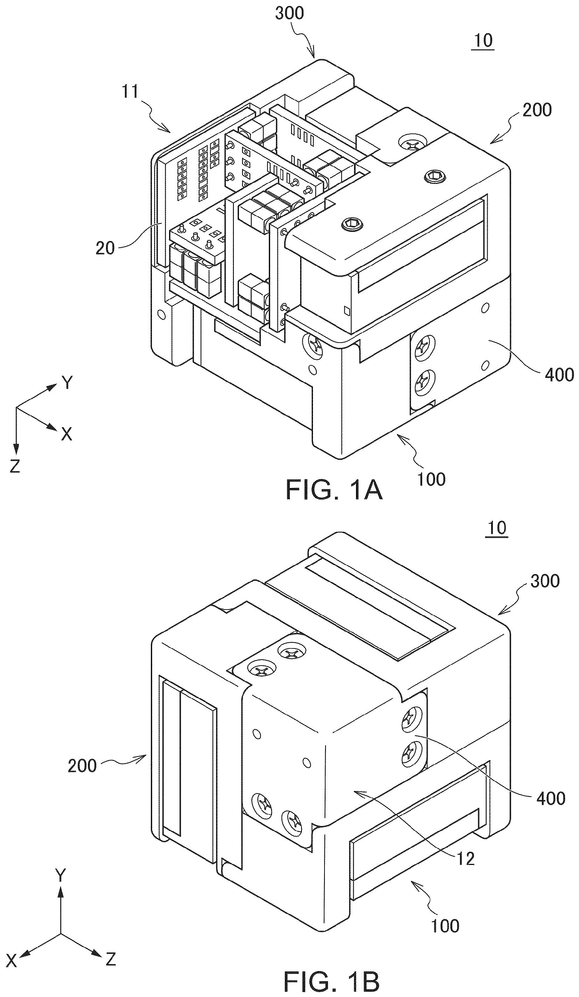

FIGS. 1A and 1B are schematic perspective views illustrating the outer appearance of a magnetic field detection device 10 according to an embodiment of the technology described herein, as viewed from different directions.

As illustrated in FIGS. 1A and 1B, the magnetic field detection device 10 according to the present embodiment includes three magnetic sensor modules 100, 200, and 300, a fixing member 400, and a circuit board 20. The magnetic sensor modules 100, 200, and 300 are engaged with one another in a cubic shape to form a cube body. The circuit board 20 is disposed at a corner region 11 of the cube body. The fixing member 400 is disposed at a corner region 12 of the cube body. The corner regions 11 and 12 are located diagonally opposite to each other.

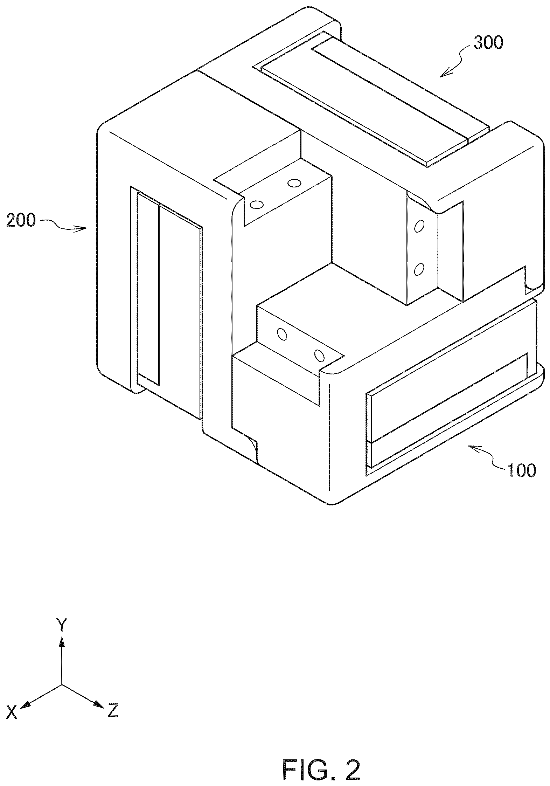

FIG. 2 is a schematic perspective view illustrating a state in which the fixing member 400 is removed from the magnetic field detection device 10.

As illustrated in FIG. 2, a space is formed at the corner region 12 of the cube body when the fixing member 400 is removed. The XZ surface of the magnetic sensor module 100, the XY surface of the magnetic sensor module 200, and the YZ surface of the magnetic sensor module 300 are exposed in the space. The X-, Y-, and Z-directions are orthogonal to one another. The fixing member 400 is disposed in the space and threadably fastened to the magnetic sensor modules 100, 200, and 300 using screws, whereby these members are mutually fixed. In this state, each pair of the magnetic sensor modules 100, 200, and 300 is mutually fixed by screw-fastening.

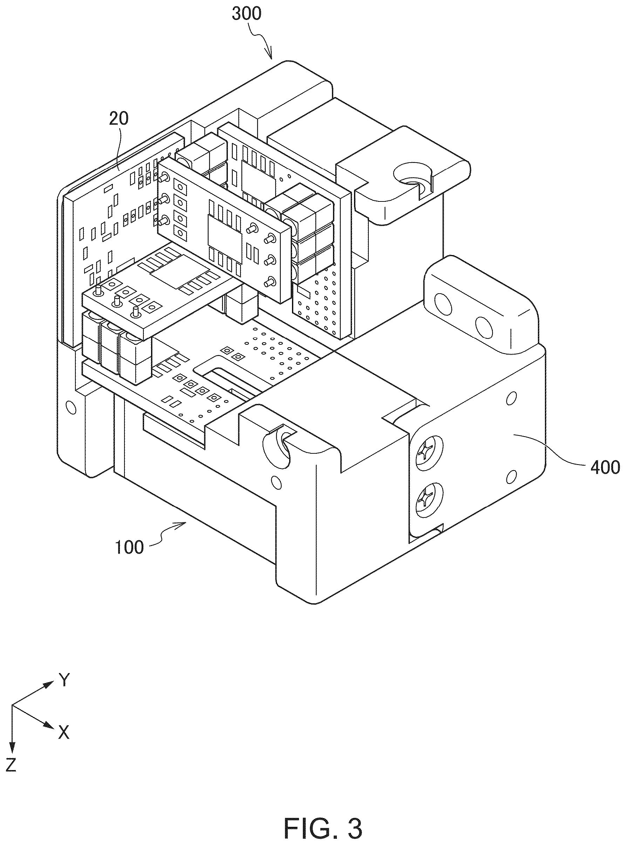

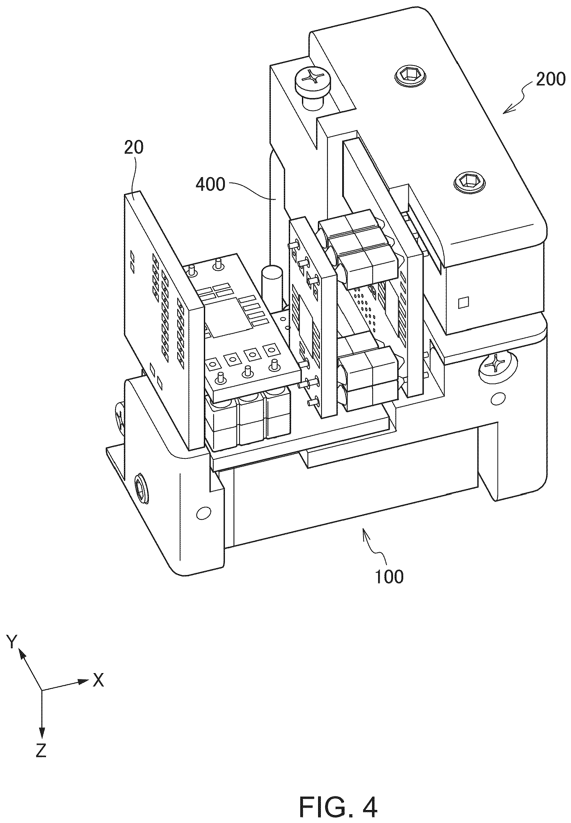

FIG. 3 is a schematic perspective view illustrating a state in which the magnetic sensor module 200 is removed from the magnetic field detection device 10. FIG. 4 is a schematic perspective view illustrating a state in which the magnetic sensor module 300 is removed from the magnetic field detection device 10.

As illustrated in FIGS. 3 and 4, the magnetic sensor module 100 and the fixing member 400 are connected to each other in the Y-direction, the magnetic sensor module 200 and the fixing member 400 are connected to each other in the Z-direction, and the magnetic sensor module 300 and the fixing member 400 are connected to each other in the X-direction. The magnetic sensor modules 100 and 200 are connected in the Z-direction, the magnetic sensor modules 100 and 300 are connected in the Y-direction, and the magnetic sensor modules 200 and 300 are connected in the X-direction.

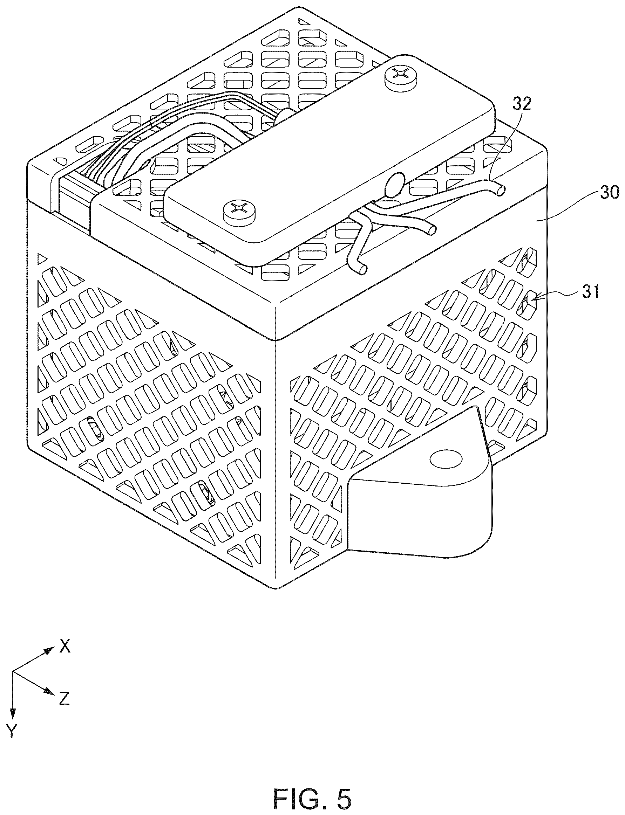

FIG. 5 is a schematic perspective view illustrating a state in which the cube body constituting the magnetic field detection device 10 is accommodated in an outer case 30.

As illustrated in FIG. 5, the outer case 30 is provided with a plurality of ventilation holes 31 on its wall surfaces, whereby heat generated from the magnetic field detection device 10 is efficiently dissipated outward. The outer case 30 is made of resin, for example. Cables 32 drawn out from the magnetic field detection device 10 through the outer case 30 are connected to the magnetic sensor modules 100, 200, and 300, respectively, through the circuit board 20.

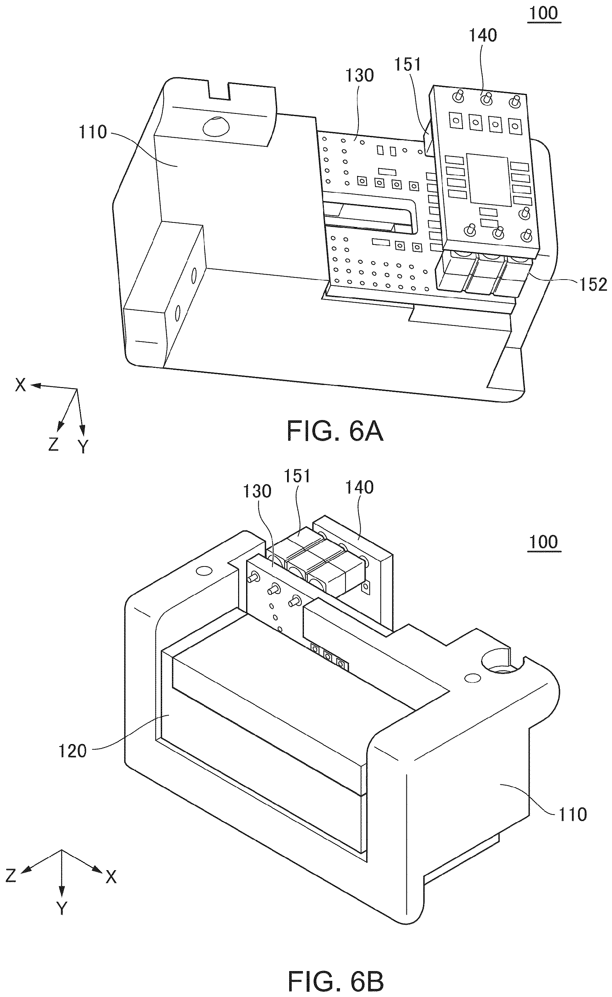

FIGS. 6A and 6B are schematic perspective views illustrating the outer appearance of the magnetic sensor module 100, as viewed from different directions.

As illustrated in FIGS. 6A and 6B, the magnetic sensor module 100 includes a support body 110, a magnetic sensor 120 fixed to the support body 110, a circuit board 130 fixed to the support body 110, and a circuit board 140 fixed, through connection members 151 and 152, to the circuit board 130 so as to overlap the circuit board 130. The support body 110 may be formed of a molded resin.

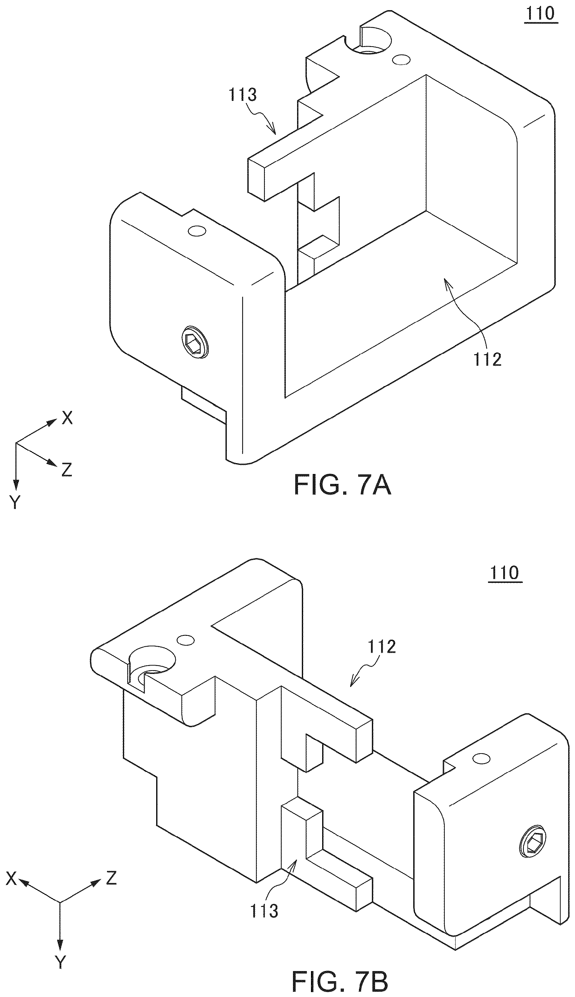

FIGS. 7A and 7B are schematic perspective views illustrating the outer appearance of the support body 110, as viewed from different directions.

As illustrated in FIGS. 7A and 7B, the support body 110 is elongated in the X-direction, and includes an accommodating part 112 extending in the X-direction and an accommodating part 113 that overlaps the accommodating part 112 in the Z-direction. The accommodating part 112 accommodates the magnetic sensor 120. The accommodating part 113 accommodates the circuit board 130. The circuit board 130 is connected to the magnetic sensor 120. The circuit board 140 is connected to the magnetic sensor 120 through the connection members 151 and 152 and the circuit board 130. The main surfaces of the circuit boards 130 and 140 both face the negative Z-direction. That is, the main surface of the circuit board 130 and the back surface of the circuit board 140 face each other in the Z-direction with a space interposed therebetween. This allows air to circulate in the X-direction through the space formed between the circuit boards 130 and 140.

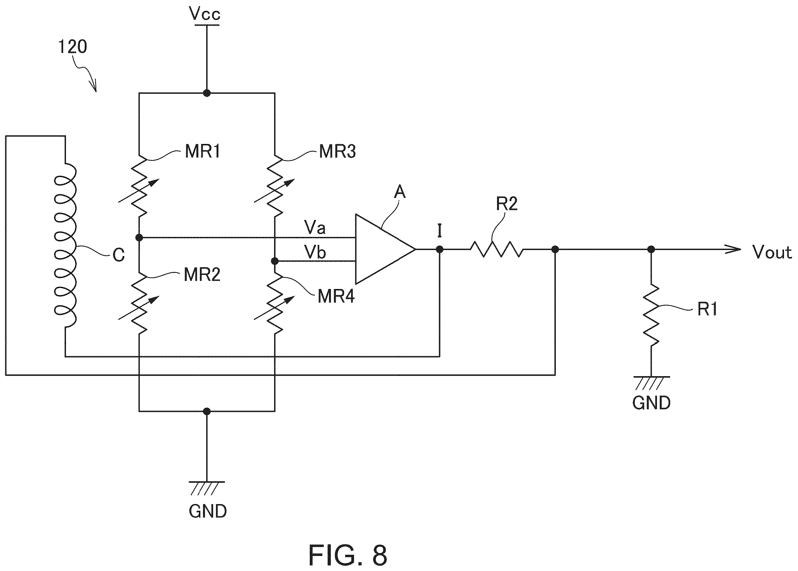

FIG. 8 is a circuit diagram illustrating an example of a circuit formed in the magnetic sensor 120 and the circuit boards 130 and 140.

In the example illustrated in FIG. 8, the magnetic sensor 120 includes four sensor elements MR1 to MR4 configured to detect an X-direction magnetic field and a compensating coil C configured to generate a magnetic field for canceling the external magnetic field applied to the sensor elements MR1 to MR4. The sensor elements MR1 and MR2 are connected in series, and a detection signal Va is output from a node therebetween. The sensor elements MR3 and MR4 are connected in series, and a detection signal Vb is output from a node therebetween. A potential difference between the detection signals Va and Vb generated by such a bridge circuit is amplified by a differential amplifier A, thereby generating a compensating current I. A current value of the compensating current I is converted into a voltage by a resistor R1, thereby generating an output signal Vout. The output signal Vout is a final output signal of the magnetic sensor module 100. Further, the compensating current I is divided into a shunt resistor R2 and the compensating coil C, which are connected in parallel, and a cancelling magnetic field generated by a portion of the compensating current I flowing through the compensating coil C is applied to the sensor elements MR1 to MR4. Alternatively, the entire compensating current I may be caused to flow through the compensating coil C without using the shunt resistor R2.

In the circuit configuration illustrated in FIG. 8, the sensor elements MR1 to MR4 and the compensating coil C are integrated on the magnetic sensor 120, a bridge circuit bridge-connecting the sensor elements MR1 to MR4 and the differential amplifier A are formed on the circuit board 140, a compensating circuit including the shunt resistor R2 is formed on the circuit board 130, and the resistor R1 is also formed on the circuit board 130.

As illustrated in FIG. 6A, the connection member 151 supports the circuit board 140 so as to form a space between the circuit boards 130 and 140. This enhances heat dissipation performance of the circuit board 130, which generates a large amount of heat due to the compensating current I. Further, on the circuit board 130, wiring is formed so as to cause the compensating current I or a divided portion thereof to flow in the X-direction. For example, the shunt resistor R2, through which a portion of the compensating current I flows, extends in the X-direction on the circuit board 130. The X-direction corresponds to the sensitivity axis direction of the magnetic sensor 120. Thus, a magnetic field generated by the compensating current I or a divided portion thereof flowing on the circuit board 130 circulates about an axis extending in the X-direction, and is therefore unlikely to cause noise in the magnetic sensor 120. A current flowing through the resistor R1 may also be caused to flow in the X-direction, which is the sensitivity axis direction of the magnetic sensor 120.

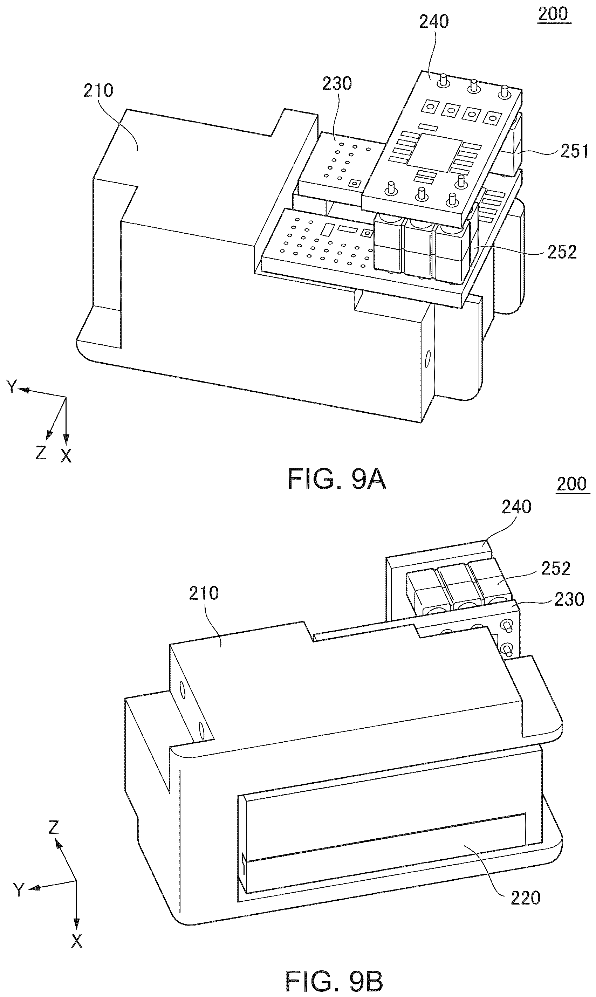

FIGS. 9A and 9B are schematic perspective views illustrating the outer appearance of the magnetic sensor module 200, as viewed from different directions.

As illustrated in FIGS. 9A and 9B, the magnetic sensor module 200 includes a support body 210, a magnetic sensor 220 fixed to the support body 210, a circuit board 230 fixed to the support body 210, and a circuit board 240 fixed, through connection members 251 and 252, to the circuit board 230 so as to overlap the circuit board 230. The support body 210 may be formed of a molded resin.

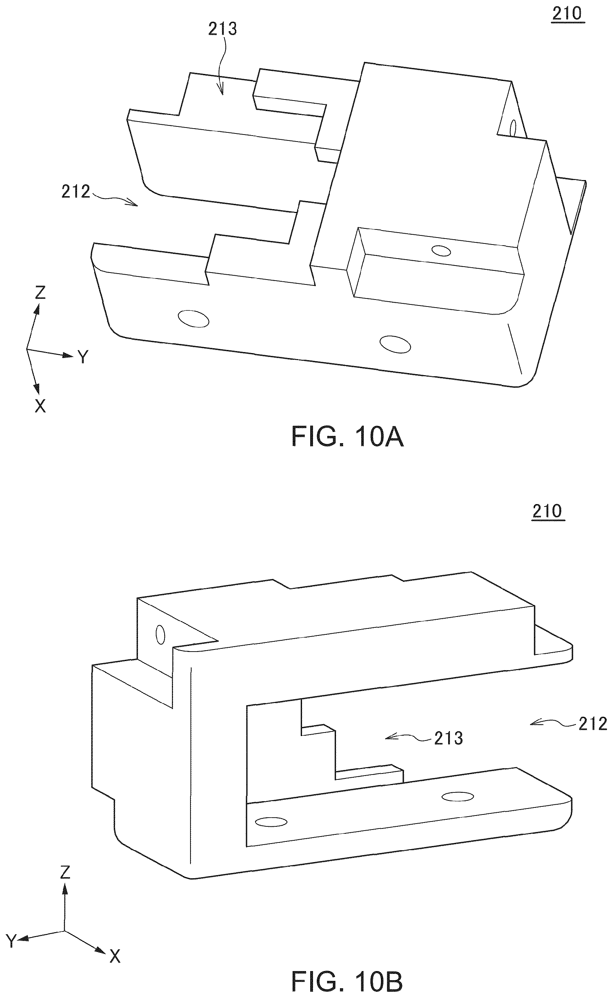

FIGS. 10A and 10B are schematic perspective views illustrating the outer appearance of the support body 210, as viewed from different directions.

As illustrated in FIGS. 10A and 10B, the support body 210 is elongated in the Y-direction, and includes an accommodating part 212 extending in the Y-direction and an accommodating part 213 that overlaps the accommodating part 212 in the X-direction. The accommodating part 212 accommodates the magnetic sensor 220. The accommodating part 213 accommodates the circuit board 230. The circuit board 230 is connected to the magnetic sensor 220. The circuit board 240 is connected to the magnetic sensor 220 through the connection members 251 and 252 and the circuit board 230. The main surfaces of the circuit boards 230 and 240 both face the negative X-direction. That is, the main surface of the circuit board 230 and the back surface of the circuit board 240 face each other in the X-direction with a space interposed therebetween. This allows air to circulate in the Y-direction through the space formed between the circuit boards 230 and 240.

A circuit formed on the magnetic sensor 220 and the circuit boards 230 and 240 is as illustrated in FIG. 8.

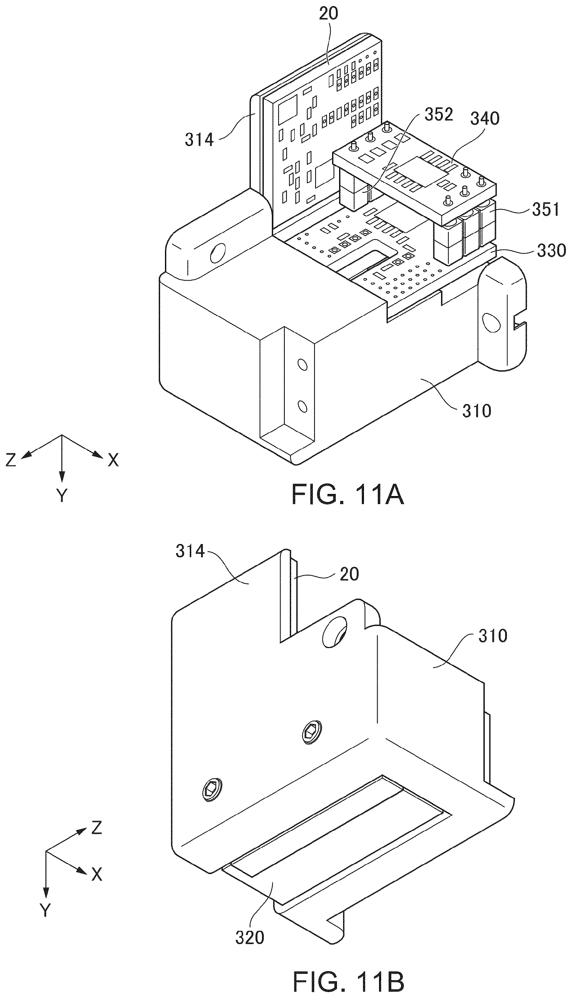

FIGS. 11A and 11B are schematic perspective views illustrating the outer appearance of the magnetic sensor module 300, as viewed from different directions.

As illustrated in FIGS. 11A and 11B, the magnetic sensor module 300 includes a support body 310, a magnetic sensor 320 fixed to the support body 310, a circuit board 330 fixed to the support body 310, and a circuit board 340 fixed, through connection members 351 and 352, to the circuit board 330 so as to overlap the circuit board 330. The support body 310 may be formed of a molded resin.

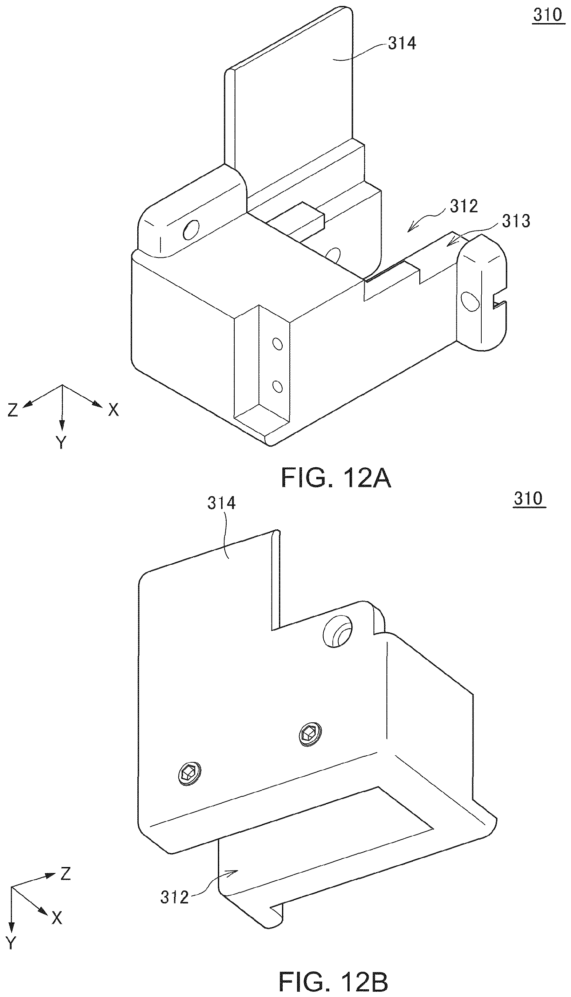

FIGS. 12A and 12B are schematic perspective views illustrating the outer appearance of the support body 310, as viewed from different directions.

As illustrated in FIGS. 12A and 12B, the support body 310 is elongated in the Z-direction, and includes an accommodating part 312 extending in the Z-direction, an accommodating part 313 that overlaps the accommodating part 312 in the Y-direction, and a plate-shaped part 314 having the YZ surface. The accommodating part 312 accommodates the magnetic sensor 320. The accommodating part 313 accommodates the circuit board 330. The circuit board 330 is connected to the magnetic sensor 320. The circuit board 340 is connected to the magnetic sensor 320 through the connection members 351 and 352 and the circuit board 330. The main surfaces of the circuit boards 330 and 340 both face the negative Y-direction. That is, the main surface of the circuit board 330 and the back surface of the circuit board 340 face each other in the Y-direction with a space interposed therebetween. This allows air to circulate in the Z-direction through the space formed between the circuit boards 330 and 340.

A circuit formed on the magnetic sensor 320 and the circuit boards 330 and 340 is as illustrated in FIG. 8.

The plate-shaped part 314 of the support body 310 has the circuit board 20 thereon. The circuit board 20 is connected to the circuit board 140 included in the magnetic sensor module 100, the circuit board 240 included in the magnetic sensor module 200, and the circuit board 340 included in the magnetic sensor module 300. As a result, the magnetic sensor modules 100, 200, and 300 are controlled by the circuit board 20, and the output signals Vout from the magnetic sensor modules 100, 200, and 300 are supplied to the circuit board 20.

In the present embodiment, the support body 110 included in the magnetic sensor module 100, the support body 210 included in the magnetic sensor module 200, and the support body 310 included in the magnetic sensor module 300 have mutually different shapes. This facilitates discrimination among the support bodies 110, 210, and 310 during assembly. However, this is not essential, and the support bodies 110, 210, and 310 may have the same shape.

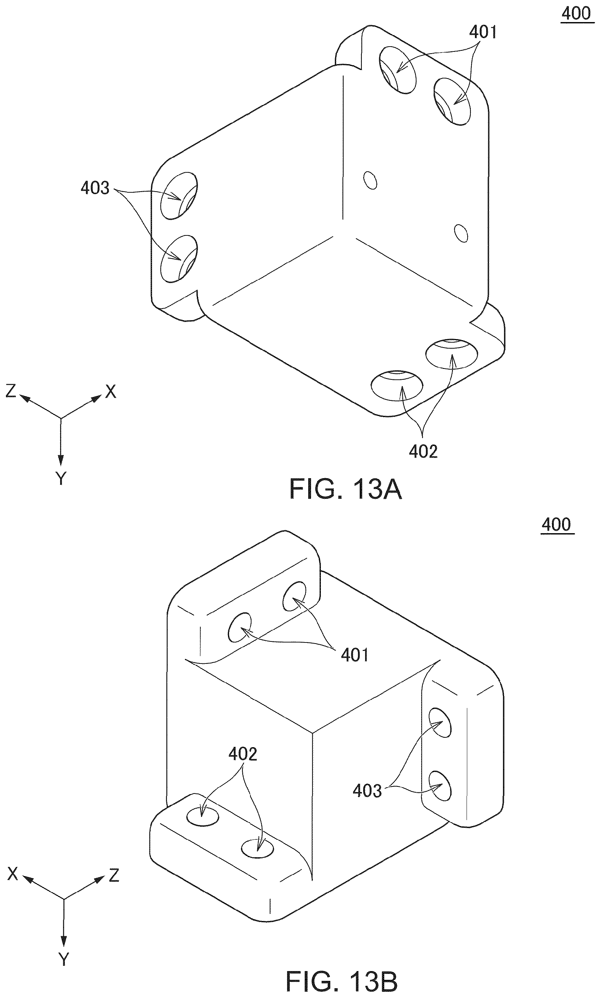

FIGS. 13A and 13B are schematic perspective views illustrating the outer appearance of the fixing member 400, as viewed from different directions.

As illustrated in FIG. 13A and 13B, the fixing member 400 has screw holes 401 to 403. The fixing member 400 and the magnetic sensor module 100 are fixed to each other by screws inserted into the screw holes 401, the fixing member 400 and the magnetic sensor module 200 are fixed to each other by screws inserted into the screw holes 402, and the fixing member 400 and the magnetic sensor module 300 are fixed to each other by screws inserted into the screw holes 403.

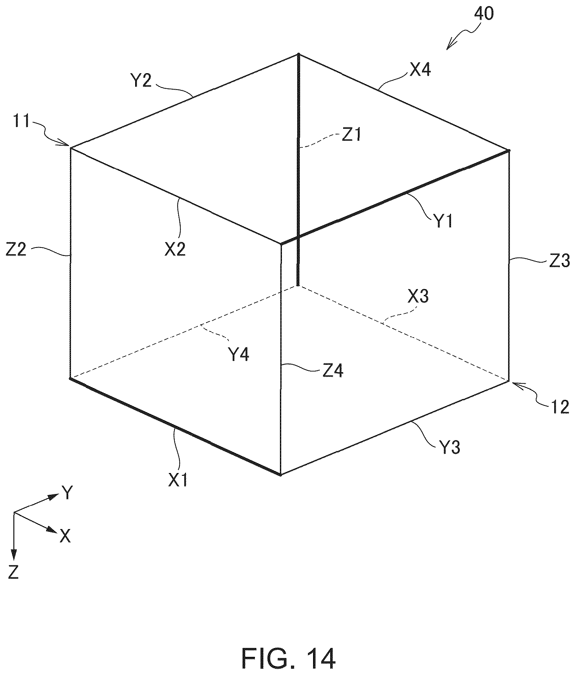

FIG. 14 is a schematic view of a cube body 40 formed by the magnetic sensor modules 100, 200, and 300.

As illustrated in FIG. 14, the cube body 40 has a substantially cube shape, and includes sides X1 to X4 extending in the X-direction, sides Y1 to Y4 extending in the Y-direction, and sides Z1 to Z4 extending in the Z-direction. The magnetic sensor 120 having a sensitivity axis direction extending along the X-axis is disposed at a position corresponding to the side X1, the magnetic sensor 220 having a sensitivity axis direction extending along the Y-axis is disposed at a position corresponding to the side Y1, and the magnetic sensor 320 having a sensitivity axis direction extending along the Z-axis is disposed at a position corresponding to the side Z1. This allows the magnetic field detection device 10 to detect a magnetic field in three-axis directions.

The sides X1, Y1, and Z1 are located at positions that do not share corners with one another. Since the magnetic sensors 120, 220, and 320 are respectively disposed along the sides X1, Y1, and Z1 that do not intersect with one another (that do not have common vertices) of the cube body 40, a sufficient distance can be ensured between sensor heads of the magnetic sensors 120, 220, and 320. This makes it possible to reduce magnetic interference between the magnetic sensors 120, 220, and 320.

Further, a corner formed by the side X2, the side Y2, and the side Z2 is located at the corner region 11, the side X2 being located at the same position in the Y-direction as and at a different position in the Z-direction from the side X1, the side Y2 being located at the same position in the Z-direction as and at a different position in the X-direction from the side Y1, the side Z2 being located at the same position in the X-direction as and at a different position in the Y-direction from the side Z1. At the corner region 11, the circuit boards 130 and 140 included in the magnetic sensor module 100, the circuit boards 230 and 240 included in the magnetic sensor module 200, the circuit boards 330 and 340 included in the magnetic sensor module 300, and the circuit board 20 are collectively disposed. More specifically, at the corner region 11, a region surrounded by the circuit boards 20, 130, 230, and 330 is formed, and the circuit boards 140, 240, and 340 are disposed so as not to interfere with one another.

As described above, the circuit boards are collectively disposed at the corner region 11, separated from the sides X1, Y1, and Z1 along which the magnetic sensors 120, 220, and 320 are respectively disposed, and are therefore unlikely to become noise sources for the magnetic sensors 120, 220, and 320.

Further, a corner formed by the side X3, the side Y3, and the side Z3 is located at the corner region 12, the side X3 being located at the same position in the Z-direction as and at a different position in the Y-direction from the side X1, the side Y3 being located at the same position in the X-direction as and at a different position in the Z-direction from the side Y1, the side Z3 being located at the same position in the Y-direction as and at a different position in the X-direction from the side Z1. Ath the corner region 12, the fixing member 400 is disposed.

As described above, the fixing member 400 is disposed at the corner region 12, separated from the sides X1, Y1, and Z1 along which the magnetic sensors 120, 220, and 320 are respectively disposed, and can therefore connect the support bodies 110, 210, and 310 to one another while preventing interference with the magnetic sensors 120, 220, and 320.

While some embodiments of the technology according to the present disclosure have been described, the technology according to the present disclosure is not limited to the above embodiments, and various modifications may be made within the scope of the present disclosure, and all such modifications are included in the technology according to the present disclosure.

The technology according to the present disclosure includes the following configuration examples, but not limited thereto.

A magnetic sensor module according to an aspect of the present disclosure includes: a support body; a magnetic sensor fixed to the support body; a first circuit board fixed to the support body and connected to the magnetic sensor; a connection member fixed to the first circuit board; a second circuit board fixed to the first circuit board through the connection member and connected to the magnetic sensor through the connection member and the first circuit board. The connection member supports the second circuit board so as to form a space between the first circuit board and the second circuit board. This allows air to circulate through the space formed between the first and second circuit boards, thereby enabling the magnetic sensor module to have excellent heat dissipation performance.

In the above magnetic sensor module, the magnetic sensor may include a plurality of sensor elements and a compensating coil, the second circuit board may include a bridge circuit configured to bridge-connect the plurality of sensor elements, and the first circuit board may include a compensating circuit configured to cause a compensating current to flow through the compensating coil based on a detection signal output from the bridge circuit. This allows heat generated by the compensating current to be dissipated through the first and second circuit boards.

In the above magnetic sensor module, the compensating current or a divided portion thereof may flow in a magnetic sensitivity direction of the magnetic sensor on the first circuit board. This makes the compensating current unlikely to become a noise source for the magnetic sensor.

A magnetic field detection device according to an aspect of the present disclosure includes first, second, and third magnetic sensor modules that have the same configurations as the above-described magnetic sensor module and are engaged with one another. The magnetic sensitivity direction of the magnetic sensor included in the first magnetic sensor module may be a first direction, the magnetic sensitivity direction of the magnetic sensor included in the second magnetic sensor module may be a second direction orthogonal to the first direction, and the magnetic sensitivity direction of the magnetic sensor included in the third magnetic sensor module may be a third direction orthogonal to the first and second directions. This allows the magnetic field detection device to detect a magnetic field in three-axis directions.

In the above magnetic field detection device, the first, second, and third sensor modules may be engaged with one another in a cubic shape to form a cube body. This makes it easy to constitute a magnetic field detection device array composed of an aggregate of a plurality of magnetic field detection devices.

The above magnetic field detection device may further include an outer case that accommodates the cube body and has a plurality of ventilation holes. Thus, the cube body is protected by the outer case, and high heat dissipation performance can be achieved by air circulation through the ventilation holes.

In the above magnetic field detection device, main surfaces of the first and second circuit boards included in the first magnetic sensor module, main surfaces of the first and second circuit boards included in the second magnetic sensor module, and main surfaces of the first and second circuit boards included in the third magnetic sensor module may be orthogonal to one another, and the first and second circuit boards included in the first, second, and third magnetic sensor modules may be collectively disposed at a first corner region of the cube body. This makes the circuit boards unlikely to become noise sources for the magnetic sensors.

The above magnetic field detection device may further include a third circuit board connected to the second circuit boards included in the first, second, and third magnetic sensor modules and disposed at the first corner region, and the third circuit board may be fixed to the support body included in any one of the first, second, and third magnetic sensor modules. This eliminates the need to separately provide a dedicated support body for supporting the third circuit board.

The above magnetic field detection device may further include a fixing member disposed at a second corner region located diagonally opposite to the first corner region of the cube body and fixed to the support bodies included in the first, second, and third magnetic sensor modules. This makes it possible to securely fix the first, second, and third magnetic sensor modules to one another.

## Claims

1. A magnetic sensor module comprising:
a support body;
a magnetic sensor fixed to the support body;
a first circuit board fixed to the support body and connected to the magnetic sensor;
a connection member fixed to the first circuit board; and
a second circuit board fixed to the first circuit board through the connection member and connected to the magnetic sensor through the connection member and the first circuit board,
wherein the connection member supports the second circuit board so as to form a space between the first circuit board and the second circuit board.

2. The magnetic sensor module as claimed in claim 1,
wherein the magnetic sensor includes a plurality of sensor elements and a compensating coil,
wherein the second circuit board includes a bridge circuit configured to bridge-connect the plurality of sensor elements, and
wherein the first circuit board includes a compensating circuit configured to cause a compensating current to flow through the compensating coil based on a detection signal output from the bridge circuit.

3. The magnetic sensor module as claimed in claim 2, wherein the compensating current or a divided portion thereof flows in a magnetic sensitivity direction of the magnetic sensor on the first circuit board.

4. A magnetic field detection device comprising first, second, and third magnetic sensor modules that have the same configurations as the magnetic sensor module as claimed in any one of claims 1 to 3 and are engaged with one another,
wherein a magnetic sensitivity direction of the magnetic sensor included in the first magnetic sensor module is a first direction,
wherein a magnetic sensitivity direction of the magnetic sensor included in the second magnetic sensor module is a second direction orthogonal to the first direction, and
wherein a magnetic sensitivity direction of the magnetic sensor included in the third magnetic sensor module is a third direction orthogonal to the first and second directions.

5. The magnetic field detection device as claimed in claim 4, wherein the first, second, and third sensor modules are engaged with one another in a cubic shape to form a cube body.

6. The magnetic field detection device as claimed in claim 5, further comprising an outer case that accommodates the cube body and has a plurality of ventilation holes.

7. The magnetic field detection device as claimed in claim 5,
wherein main surfaces of the first and second circuit boards included in the first magnetic sensor module, main surfaces of the first and second circuit boards included in the second magnetic sensor module, and main surfaces of the first and second circuit boards included in the third magnetic sensor module are orthogonal to one another, and
wherein the first and second circuit boards included in the first, second, and third magnetic sensor modules are collectively disposed at a first corner region of the cube body.

8. The magnetic field detection device as claimed in claim 7, further comprising a third circuit board connected to the second circuit boards included in the first, second, and third magnetic sensor modules and disposed at the first corner region, and
wherein the third circuit board is fixed to the support body included in any one of the first, second, and third magnetic sensor modules.

9. The magnetic field detection device as claimed in claim 7, further comprising a fixing member disposed at a second corner region located diagonally opposite to the first corner region of the cube body and fixed to the support bodies included in the first, second, and third magnetic sensor modules.
